# EUROPEAN PATENT SPECIFICATION

(11) **EP 3 576 502 B1**
(45) Date of publication and mention of the grant of the patent: **27.12.2023**
(21) Application number: 19171436.9
(22) Date of filing: 26.04.2019
(51) Int. Cl.: H05K 1/02

(54) **METHOD FOR MANUFACTURING CIRCUIT BOARD**
VERFAHREN ZUR HERSTELLUNG VON LEITERPLATTE
PROCEDE DE FORMATION DE CARTE DE CIRCUIT IMPRIME

(30) Priority: 30.05.2018 JP 2018103319
(43) Date of publication of application: 04.12.2019
(73) Proprietor: TOYOTA JIDOSHA KABUSHIKI KAISHA, Toyota-shi, Aichi-ken 471 8571 (JP)
(72) Inventor: SHINOHARA, Masatoshi, Aichi-ken,, 471-8571 (JP)
(74) Representative: J A Kemp LLP

(56) References cited:
- WO-A1-2014/171098
- US-A1- 2014 168 913
- US-A1- 2015 021 075

## Description

### BACKGROUND OF THE INVENTION

### 1. Field of the Invention

The present invention relates to a method of forming a stress relieving portion for relieving stress on a circuit board.

### 2. Description of Related Art

A circuit board having a plurality of fastening holes (holes for screw fastening) has been hitherto proposed as this type of circuit board (e.g., see Japanese Patent Application Publication No. 2016-162944). In this circuit board, a slit is formed around each fastening hole so as to surround the fastening hole, and a region surrounded by the slit is coupled to a region on the opposite side of the slit through only a single coupling portion at an outer edge of the circuit board. This feature is described as being able to reduce distortion due to stress occurring between the fastening holes when the circuit board is fastened with screws. WO2014/171098 A1 discloses an electronic device for a vehicle is provided with a metal member (5), a printed wiring board (4), and a first semiconductor package (30). A first through hole (4y) for having a screw (12) inserted therethrough is provided in the printed wiring board (4). The screw (12) is used to fix the printed wiring board (4) to the metal member (5). The first semiconductor package (30) is soldered to the printed wiring board (4). Furthermore, in the printed wiring board (4), a slit (4yb) is provided between a position where the first through hole (4y) is provided and a position where the first semiconductor package (30) is disposed. Accordingly, concentration of stress applied to the printed wiring board (4) by fastening the screw is attenuated and warping of the printed wiring board (4) is suppressed, and as a result, crack formation in soldered portions of the semiconductor package (30) is inhibited and electrical connections are improve. US 2015/021075 A1 discloses a surface mounting substrate for surface mounting an electronic part using a lead-free solder includes a joint portion of the substrate to which the electronic parts is joined; and a stress relaxation portion formed in a vicinity of the joint portion of the substrate. US 2014/168913 A1 discloses a continuous substrate including a first portion with a plurality of electronic components, and at least one strain relief area located proximate a fastening location, wherein the at least one strain relief area is located between the first portion and the fastening location.

### SUMMARY OF THE INVENTION

However, the slit formed in the above circuit board cuts a portion between fastening points that serves as a beam during vibration, causing a decrease in the rigidity and the resonance frequency of the circuit board. As a result, resonance is more likely to occur when the frequency of vibration input into the circuit board is low, and thus the anti-vibration performance of the circuit board may decrease.

The present invention provides a method of forming a stress relieving portion on a circuit board as defined in the independent claims.

A circuit board has a plurality of fastening holes used to fasten the circuit board to the predetermined part, and these fastening holes include a first fastening hole and a second fastening hole. The circuit board has a plurality of electronic components mounted on a surface thereof. The circuit board has a stress relieving portion for relieving stress provided around the first fastening hole, and the stress relieving portion is provided in a region that does not intersect with a straight line connecting the first fastening hole and the second fastening hole located adjacent to the first fastening hole.

Around the fastening hole, the stress relieving portion for relieving stress is provided in a region that does not intersect with the straight line connecting the fastening hole and another adjacent fastening hole. With a beam thus formed between the two adjacent fastening holes, this circuit board has higher rigidity when fastened to the predetermined part by the fasteners inserted into the fastening holes, than a circuit board that has a stress relieving portion provided on a straight line connecting two adjacent fastening holes. As a result, it is possible to suppress a decrease in the resonance frequency of the circuit board, and to suppress a decrease in the anti-vibration performance of the circuit board.

Around the first fastening hole from which the distance to another adjacent fastening hole is smaller than a predetermined distance, the stress relieving portion may be provided in a region intersecting with the straight line. Here, the "predetermined distance" is determined in advance by experiment, analysis, etc. as a threshold value of the distance between two fastening holes at which the rigidity of the circuit board against vibration that is input into the circuit board having been fastened to the predetermined part by the fasteners, starts to decrease due to formation of the stress relieving portion. For two adjacent fastening holes between which the distance is smaller than the predetermined distance, forming the stress relieving portion on the straight line connecting the two fastening holes causes neither a significant decrease in the rigidity of a portion between the fastening holes nor a significant decrease in the resonance frequency of the circuit board. From the viewpoint of reducing the distortion of the circuit board, it is desirable that the stress relieving portion be formed as far as possible between two fastening holes to relieve stress on the circuit board. Therefore, around the fastening hole from which the distance to an adjacent fastening hole is smaller than the predetermined distance, the stress relieving portion can be formed without avoiding the straight line, to thereby further reduce the distortion of the circuit board occurring when the circuit board is fastened to the predetermined part by the fasteners inserted into the fastening holes.

An electronic component that develops an abnormality when a predetermined distortion stress is applied to the circuit board may be disposed on the straight line connecting the first fastening hole and an adjacent second fastening hole. Around the first fastening hole and the second fastening hole, the stress relieving portion may be provided in a region intersecting with the straight line. Thus, when a predetermined distortion stress is applied to the circuit board, the resulting stress on the circuit board is relieved by the stress relieving portion, so that the distortion of the circuit board can be suppressed and the electronic component can be protected.

An electronic component that develops the abnormality when a distortion stress equivalent to an average value of a degree of distortion that is input into the circuit board in a state of not having the stress relieving portion is applied to the circuit board, may be disposed as the electronic component. Thus, when a predetermined distortion stress is applied to the circuit board, the resulting stress on the circuit board is relieved by the stress relieving portion, so that the distortion of the circuit board can be suppressed and the electronic component can be protected.

A resistor element or an integrated circuit may be disposed as the electronic component. Thus, when a predetermined distortion stress is applied to the circuit board, the resulting stress on the circuit board is relieved by the stress relieving portion, so that the distortion of the circuit board can be suppressed and the resistor element or the integrated circuit can be protected.

Furthermore, in the first aspect of the present invention, the stress relieving portion may be formed as a through-hole around the fastening hole. Thus, the stress relieving portion can be formed as the through-hole around the fastening hole.

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG. 1 is an exploded perspective view schematically showing the configuration of a PCU 10 equipped with a circuit board of an embodiment;
FIG. 2 is an illustration schematically showing the configuration of a circuit board 40;
FIG. 3 is an enlarged view of a fastening hole 42a of the circuit board 40;
FIG. 4 is a schematic view schematically showing a main part of a circuit board 140 of a modified example;
FIG. 5 is a schematic view schematically showing a main part of a circuit board 240 of a modified example;
FIG. 6 is a schematic view schematically showing a main part of a circuit board 340 of a modified example;
FIG. 7 is a schematic view schematically showing a section of a main part of a circuit board 440 of a modified example; and
FIG. 8 is a schematic view schematically showing a section of a main part of a circuit board 540 of a modified example.

### DETAILED DESCRIPTION OF EMBODIMENTS

Next, a mode for carrying out the present invention will be described using an embodiment.

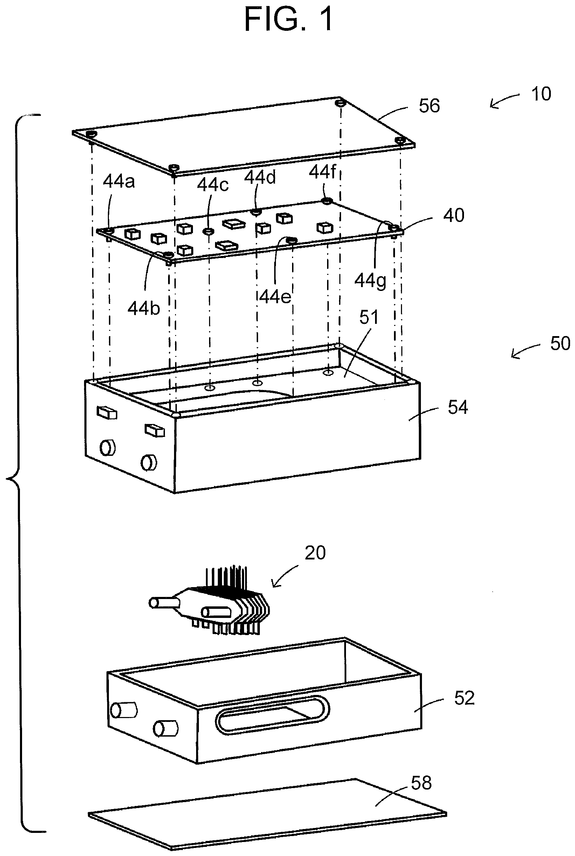

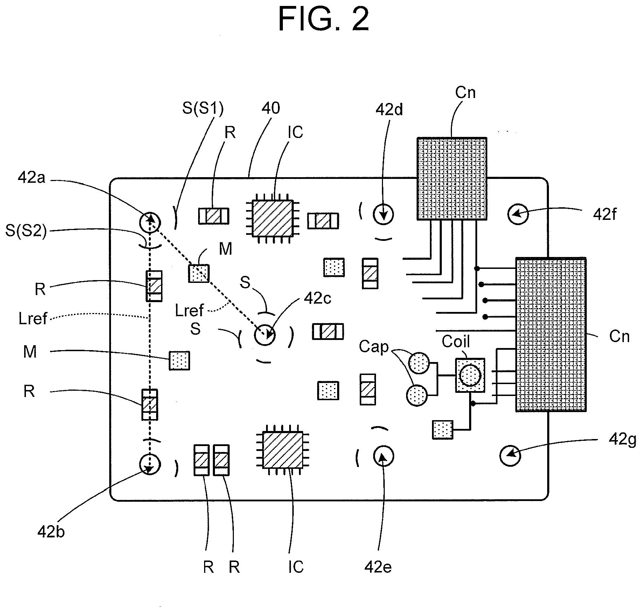

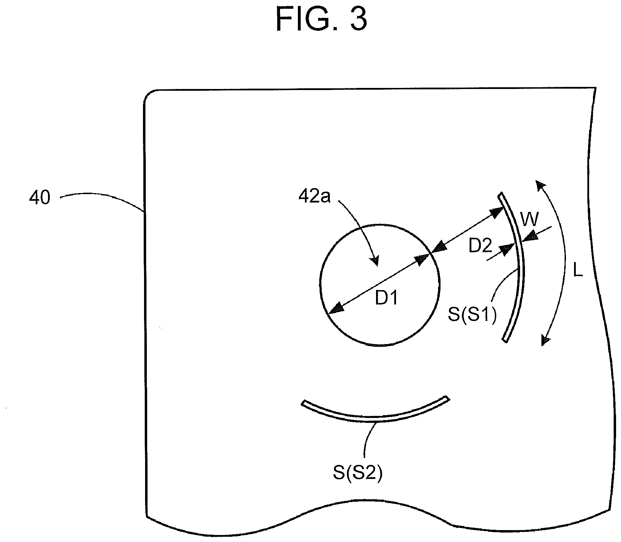

FIG. 1 is an exploded perspective view schematically showing the configuration of a power control unit (hereinafter referred to as a "PCU") 10 equipped with a circuit board of the embodiment. FIG. 2 is an illustration schematically showing the configuration of a circuit board 40. FIG. 3 is an enlarged view of a fastening hole 42a of the circuit board 40. As shown in FIG. 1, the PCU 10 includes a power converter 20, the circuit board 40, and a casing 50. For example, the PCU 10 is installed in a hybrid vehicle that runs on power from an engine or power from a motor, and functions as a control device that controls the motor.

The power converter 20 has a plurality of built-in power elements including a diode and an IGBT that compose a circuit for converting electricity, such as a boost converter or an inverter.

As shown in FIG. 2, the circuit board 40 has a plurality of electronic components mounted thereon that compose a control circuit for controlling the boost converter or the inverter built in the power converter 20. Examples of the electronic components include a resistor element R, an integrated circuit IC, a connector Cn, an electrolytic capacitor Cap, a coil Coil, and a metal-oxide-semiconductor field-effect transistor (MOSFET; hereinafter referred to as a "transistor") M. When a predetermined degree of distortion stress that is determined in advance is applied to the circuit board 40, the resistor element R and the integrated circuit IC are more likely to develop an abnormality, such as cracking, than the electrolytic capacitor Cap, the coil Coil, and the transistor M. The "predetermined degree" is a degree that is determined in advance as an average value of a degree of distortion input into the circuit board 40 in a state of not having slits S, to be described later, formed therein. In the circuit board 40, fastening holes 42a to 42g and a plurality of slits S (slits S1, S2, etc.) are formed. As shown in FIG. 1, the circuit board 40 is fixed to a mount member 51 of the casing 50 by screws 44a to 44g inserted into the fastening holes 42a to 42g.

As shown in FIG. 3, the fastening holes 42a to 42g have a diameter of a value D1 (e.g., 4 mm, 5 mm, or 6 mm) and are formed so as to extend through the circuit board 40. As shown in FIG. 2 and FIG. 3, the slits S are formed around the fastening holes 42a to 42e. The slits S1, S2 around the fastening hole 42a are formed so as to extend through the circuit board 40, at positions separated from the fastening hole 42a by a distance D2 (e.g., 3.0 mm, 3.5 mm, or 4.0 mm), and have an arc shape with a width W (e.g., 0.8 mm, 1.0 mm, or 1.2 mm) and an arc length of a value L (e.g., 5 mm, 6 mm, or 7 mm). The slit S2 is disposed at a position defined by turning the slit S1 90 degrees around a central axis of the fastening hole 42a as a rotational axis. The slits S around the fastening holes 42b to 42e are formed in the same shape as the slits S1, S2. When the slits S are disposed around the fastening holes 42b to 42e, the slits S are disposed such that one slit S is located at a position defined by turning the other slit S 90 degrees around the central axis of the fastening hole 42a as the rotational axis. Details of the arrangement of the slits S will be described later.

The casing 50 includes cases 52, 54, a lid member 56, and a bottom member 58. The power converter 20 is housed in the case 52, and the case 52 is fitted in the case 54 in a state of being closed at a lower side as seen in FIG. 1 by the bottom member 58. The circuit board 40 is fixed to an upper side as seen in FIG. 1 of the mount member 51 inside the case 54, and the case 52 housing the power converter 20 is fitted in the case 54 from the lower side as seen in FIG. 1 and fixed to the mount member 51.

Here, the arrangement of the slits S formed around the fastening holes 42a to 42e of the circuit board 40 will be described by using the fastening hole 42a as an example. The arrangement of the slits S is determined after the arrangement of the fastening holes 42a to 42g and the electronic components of the circuit board 40 is determined.

First, a distance Dh between the fastening hole 42a and adjacent fastening holes (fastening holes 42b, 42c and 42d) is measured. When the distance Dh is smaller than a predetermined distance Dref, the slit S is formed so as to overlap a straight line Lref connecting the center of the fastening hole 42a and the center of the adjacent fastening hole, without avoiding the straight line Lref. In this embodiment, the straight line Lref is a straight line connecting the center of the fastening hole 42a and the center of the adjacent fastening hole. However, the straight line Lref is not limited to the straight line connecting the center of the fastening hole 42a and the center of the adjacent fastening hole, and may be any straight line that connects a certain position in the fastening hole 42a and a certain position in the adjacent fastening hole. The predetermined distance Dref is determined in advance by experiment, analysis, etc. as a distance at which the likelihood of resonance of the circuit board 40 in response to low-frequency vibration starts to increase, because of a decrease in the rigidity of a region between the fastening hole 42a and the adjacent fastening hole due to formation of the slit S, and because of a significant decrease in the resonance frequency of the circuit board 40 occurring when the circuit board 40 is fixed to the casing 50 by the screws 44a to 44g inserted into the fastening holes 42a to 42g. When the distance Dh is smaller than the predetermined distance Dref, the resonance frequency of the circuit board 40 does not significantly decrease even when the slit S is formed at a position overlapping the straight line Lref. From the viewpoint of reducing the distortion of the circuit board 40, it is desirable that the slit S be formed as far as possible between two fastening holes. Therefore, when the distance Dh is smaller than the predetermined distance Dref, the slit S can be formed at a position overlapping the straight line Lref, such that, when distortion stress is applied to the circuit board 40, the resulting stress on the circuit board 40 can be relieved by the slit S. As a result, the distortion of the circuit board 40 can be suppressed.

When the distance Dh is equal to or larger than the predetermined distance Dref and the resistor element R or the integrated circuit IC is disposed on the straight line Lref, the slit S is formed so as to overlap the straight line Lref, without avoiding the straight line Lref. The resistor element R and the integrated circuit IC are more susceptible to distortion stress than the electrolytic capacitor Cap, the coil Coil, the transistor M, and the connector Cn. Therefore, when the distance Dh is equal to or larger than the predetermined distance Dref and the resistor element R or the integrated circuit IC is disposed on the straight line Lref, the slit S can be formed such that, when distortion stress is applied to the circuit board 40, the resulting stress on the circuit board 40 can be relieved by the slit S. As a result, it is possible to suppress the distortion of the circuit board 40 and at the same time protect the electronic components that are susceptible to distortion stress, such as the resistor element R and the integrated circuit IC.

When the distance Dh is equal to or larger than the predetermined distance Dref and the electrolytic capacitor Cap, the coil Coil, or the transistor M is disposed on the straight line Lref or no electronic component is disposed on the straight line Lref, the slit S is formed so as to avoid the straight line Lref. The electrolytic capacitor Cap, the coil Coil, the transistor M, and the connector Cn are less susceptible to distortion stress than the resistor element R and the integrated circuit IC. Therefore, when the distance Dh is equal to or larger than the predetermined distance Dref and the electrolytic capacitor Cap, the coil Coil, or the transistor M is disposed on the straight line Lref or no electronic component is disposed on the straight line Lref, the slit S can be formed so as to avoid the straight line to thereby form a beam between the fastening hole 42a and the adjacent fastening hole. A beam formed between the fastening hole 42a and the adjacent fastening hole enhances the rigidity of the region between the fastening hole 42a and the adjacent fastening hole, so that a decrease in the resonance frequency of the circuit board 40 can be suppressed. As a result, resonance of the circuit board 40 occurring when low-frequency vibration is input into the circuit board 40 can be suppressed, and thus a decrease in the anti-vibration performance can be suppressed.

With the above considerations in mind, the slits S1, S2 are formed around the fastening hole 42a so as to avoid the straight line Lref connecting the center of the fastening hole 42a and the center of the fastening hole 42c (the distance Dh to the fastening hole 42c is equal to or larger than the predetermined distance Dref and the transistor M is disposed on the straight line Lref), and so as to overlap the straight lines Lref connecting the center of the fastening hole 42a and the centers of the fastening holes 42b, 42d (the distance Dh to each of the fastening holes 42b, 42d is equal to or larger than the predetermined distance Dref and the electrolytic capacitor Cap, the coil Coil, or the transistor M is not disposed on the straight lines Lref). The slits S are formed around the fastening holes 42b to 42e in the same manner.

Around the fastening holes 42a, 42b, 42d to 42g that are formed at positions close to edges of the circuit board 40, no slit S is formed in regions that are close to the edges of the circuit board 40. This is because the regions close to the edges of the circuit board 40 are likely to chip or crack due to vibration, and therefore a decrease in the rigidity of those regions close to the edges needs to be suppressed. Thus, a decrease in the anti-vibration performance can be further suppressed.

According to the PCU 10 equipped with the circuit board 40 of the embodiment having been described above, when the distance Dh between one of the fastening holes 42a to 42g and an adjacent fastening hole is equal to or larger than the predetermined distance Dref and the electrolytic capacitor Cap, the coil Coil, or the transistor M is disposed on the straight line Lref or no electronic component is disposed on the straight line Lref, the slit S is formed so as to avoid the straight line Lref. Thus, a decrease in the anti-vibration performance of the circuit board 40 due to a decrease in the resonance frequency thereof can be suppressed.

On the other hand, when the distance Dh is smaller than the predetermined distance Dref, the slit S is formed so as to overlap the straight line Lref connecting one of the fastening holes 42a to 42g and an adjacent fastening hole, without avoiding the straight line Lref. Thus, the distortion of the circuit board 40 can be suppressed.

Moreover, when the distance Dh is equal to or larger than the predetermined distance Dref and the resistor element R or the integrated circuit IC is disposed on the straight line Lref, the slit S is formed so as to overlap the straight line Lref, without avoiding the straight line Lref. Thus, the distortion of the circuit board 40 can be suppressed.

In the PCU 10 equipped with the circuit board 40 of the embodiment, when the distance Dh is equal to or larger than the predetermined distance Dref and the electrolytic capacitor Cap, the coil Coil, or the transistor M is disposed on the straight line Lref or no electronic component is disposed on the straight line Lref, the slit S is formed so as to avoid the straight line Lref. However, the slit S may be uniformly formed so as to avoid the straight line Lref, regardless of what type of electronic component is disposed on the straight line Lref, or of whether an electronic component is disposed on the straight line Lref.

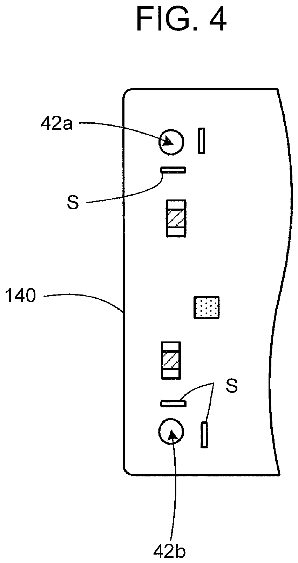

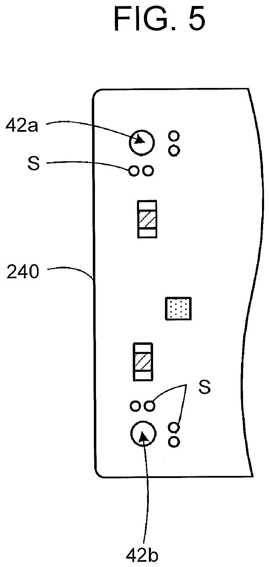

In the PCU 10 equipped with the circuit board 40 of the embodiment, the arc-shaped slits S are formed around the fastening holes 42a to 42d. However, the slits S may have any shape that can relieve stress on the circuit board 40. For example, rectangular slits S may be adopted as illustrated in a circuit board 140 of a modified example of FIG. 4. Or one or more circular slits S may be formed around each of the fastening holes 42a to 42d as illustrated in a circuit board 240 of a modified example of FIG. 5.

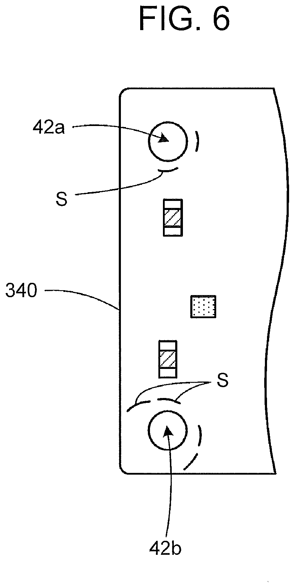

In the PCU 10 equipped with the circuit board 40 of the embodiment, the arc-shaped slits S are formed at a 90-degree interval around the fastening holes 42a to 42d. However, the arc-shaped slits S may be formed at an interval smaller than 90 degrees around the fastening holes 42a to 42d as illustrated in a circuit board 340 of a modified example of FIG. 6.

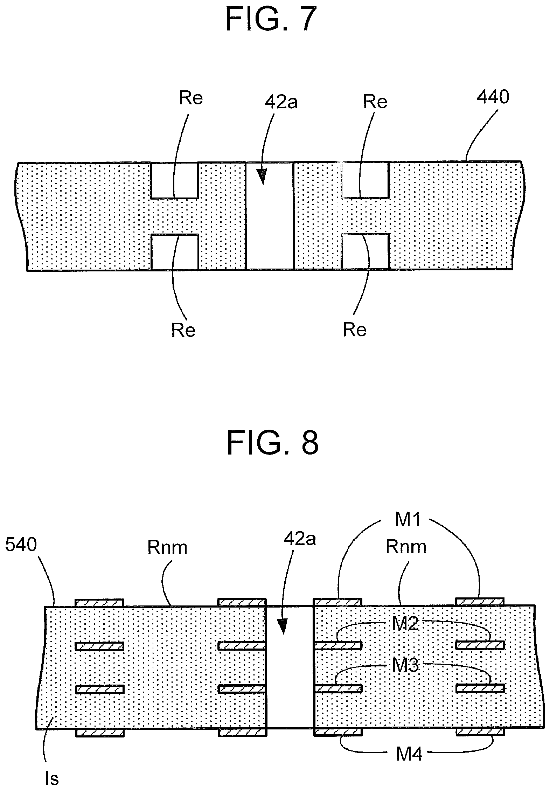

In the PCU 10 equipped with the circuit board 40 of the embodiment, the slits S are formed as through-holes extending through the circuit board 40 around the fastening holes 42a to 42d. However, what is essential is to form a structure around the fastening holes 42a to 42d that relieves stress on the circuit board 40. Therefore, as illustrated in a circuit board 440 of a modified example of FIG. 7, instead of the slits S, recesses Re may be formed on both sides of the circuit board 440, around the fastening holes 42a to 42d. The recesses Re may be formed on either both sides or only one side of the circuit board 440. Further, as illustrated in a circuit board 540 of a modified example of FIG. 8, in the case where the circuit board 540 is a multilayer board in which wiring layers M1 to M4 are sequentially formed inside an insulation material Is in a depth direction, instead of the slits S, regions Rnm having no wiring layer may be formed around the fastening holes 42a to 42d by removing portions of the wiring layers M1 to M4 around the fastening holes 42a to 42d.

In the PCU 10 equipped with the circuit board 40 of the embodiment, when the distance Dh is equal to or larger than the predetermined distance Dref and the resistor element R or the integrated circuit IC is disposed on the straight line Lref, the slit S is formed so as to overlap the straight line Lref, without avoiding the straight line Lref. However, when the distance Dh is equal to or larger than the predetermined distance Dref and an electronic component that is different from the resistor element R or the integrated circuit IC but develops an abnormality when a predetermined distortion stress is applied to the circuit board 40 is disposed on the straight line Lref, the slit S may be formed so as to overlap the straight line Lref, without avoiding the straight line Lref.

The fastening holes 42a to 42d in the embodiment are an example of the "fastening holes." The slit S is an example of the "stress relieving portion."

Since the embodiment is one example for specifically describing the mode for carrying out the invention described in SUMMARY OF THE INVENTION, the correspondence relationship between the main elements of the embodiment and the main elements of the invention described in SUMMARY OF THE INVENTION limits the elements of the invention described in that section to the elements listed in appended claims. Therefore, the invention described is limited by the appended claims.

The present invention is applicable to the circuit board manufacturing industry and the like.

## Claims

1. A method of forming a stress relieving portion (S; S1; S2) for relieving stress on a circuit board (40; 140; 240; 340; 440; 540) fastened to a predetermined part (51) by a fastener (44a; 44b; 44c; 44d; 44e; 44f; 44g), the circuit board (40; 140; 240; 340; 440; 540) having a plurality of fastening holes (42a; 42b; 42c; 42d; 42e; 42f; 42g) used to fasten the circuit board (40; 140; 240; 340; 440; 540) to the predetermined part (51), the fastening holes (42a; 42b; 42c; 42d; 42e; 42f; 42g) including a first fastening hole (42a) and a second fastening hole (42c), the circuit board (40; 140; 240; 340; 440; 540) comprising a plurality of electronic components (Cap; Coil; Cn; IC; M; R) mounted on a surface of the circuit board (40; 140; 240; 340; 440; 540), wherein the method comprises:
determining a predetermined distance which is a threshold value of a distance between two fastening holes at which the rigidity of the circuit board against vibration that is input into the circuit board having been fastened to the predetermined part by the fasteners, starts to decrease due to formation of the stress relieving portion,
measuring a distance between the first fastening hole (42a) and the adjacent second fastening hole (42c), and
forming the stress relieving portion around the first fastening hole (42a) in a region that does not intersect with a straight line (Lref) connecting the first fastening hole (42a) and the second fastening hole (42c) located adjacent to the first fastening hole (42a) when the distance between the first fastening hole and the second fastening hole is equal to or larger than the predetermined distance and an electrolytic capacitor (Cap) or a coil (Coil) or a transistor (M) or no electronic component is disposed on the straight line, forming the stress relieving portion around the first fastening hole (42a) in a region that does intersect with a straight line (Lref) connecting the first fastening hole (42a) and the second fastening hole (42c) located adjacent to the first fastening hole (42a) when the distance between the first fastening hole and the second fastening hole is larger than or equal to the predetermined distance (Dref) and a resistor element (R) or an integrated circuit (IC) is disposed on the straight line (Lref), and forming the stress relieving portion in a region intersecting with the straight line (Lref) connecting the first fastening hole (42a) and the adjacent second fastening hole (42c) when the distance (Dh) is smaller than the predetermined distance (Dref).

2. The method according to claim 1, wherein the stress relieving portion is a through-hole (S1; S2).

3. The method according to claim 1, wherein the stress relieving portion is a recess (Re).

4. The method according to claim 1, further comprising providing at least one wiring layer (M1; M2; M3; M4) that is made of metal inside the circuit board (40; 140; 240; 340; 440; 540), wherein the stress relieving portion is formed by a region (Rnm) around the fastening hole (42a) in which the wiring layer (M1; M2; M3; M4) is not provided.

## Patentansprüche

1. Verfahren zum Bilden eines Spannungsentlastungsabschnitts (S; S1; S2) zum Entlasten von Spannung an einer Leiterplatte (40; 140; 240; 340; 440; 540), die durch ein Befestigungselement (44a; 44b; 44c; 44d; 44e; 44f; 44g) an einem vorbestimmten Teil (51) befestigt ist, wobei die Leiterplatte (40; 140; 240; 340; 440; 540) eine Vielzahl von Befestigungslöchern (42a; 42b; 42c; 42d; 42e; 42f; 42g) aufweist, die verwendet werden, um die Leiterplatte (40; 140; 240; 340; 440; 540) an dem vorbestimmten Teil (51) zu befestigen, wobei die Befestigungslöcher (42a; 42b; 42c; 42d; 42e; 42f; 42g) ein erstes Befestigungsloch (42a) und ein zweites Befestigungsloch (42c) beinhalten, die Leiterplatte (40; 140; 240; 340; 440; 540) umfassend eine Vielzahl von elektronischen Komponenten (Cap; Coil; Cn; IC; M; R), die auf einer Oberfläche der Leiterplatte (40; 140; 240; 340; 440; 540) montiert sind, wobei das Verfahren Folgendes umfasst:
Bestimmen eines vorbestimmten Abstands, der ein Schwellenwert eines Abstands zwischen zwei Befestigungslöchern ist, bei dem die Steifigkeit der Leiterplatte gegen Vibrationen, die in die Leiterplatte eingeleitet werden, die durch die Befestigungselemente an dem vorbestimmten Teil befestigt wurde, aufgrund einer Bildung des Spannungsentlastungsabschnitts abzunehmen beginnt,
Messen eines Abstands zwischen dem ersten Befestigungsloch (42a) und dem angrenzenden zweiten Befestigungsloch (42c), und
Bilden des Spannungsentlastungsabschnitts um das erste Befestigungsloch (42a) in einem Bereich, der eine gerade Linie (Lref), die das erste Befestigungsloch (42a) und das zweite Befestigungsloch (42c), das sich angrenzend an das erste Befestigungsloch (42a) befindet, verbindet, nicht schneidet, wenn der Abstand zwischen dem ersten Befestigungsloch und dem zweiten Befestigungsloch gleich wie oder größer als der vorbestimmte Abstand ist und ein Elektrolytkondensator (Cap) oder eine Spule (Coil) oder ein Transistor (M) oder keine elektronische Komponente auf der geraden Linie angeordnet ist, Bilden des Spannungsentlastungsabschnitts um das erste Befestigungsloch (42a) in einem Bereich, der eine gerade Linie (Lref) schneidet, die das erste Befestigungsloch (42a) und das zweite Befestigungsloch (42c), das sich angrenzend an das erste Befestigungsloch (42a) befindet, verbindet, wenn der Abstand zwischen dem ersten Befestigungsloch und dem zweiten Befestigungsloch größer als oder gleich wie der vorbestimmte Abstand (Dref) ist und ein Widerstandselement (R) oder eine integrierte Schaltung (IC) auf der geraden Linie (Lref) angeordnet ist, und Bilden des Spannungsentlastungsabschnitts in einem Bereich, der die gerade Linie (Lref) schneidet, die das erste Befestigungsloch (42a) und das angrenzende zweite Befestigungsloch (42c) verbindet, wenn der Abstand (Dh) kleiner als der vorbestimmte Abstand (Dref) ist.

2. Verfahren nach Anspruch 1, wobei der Spannungsentlastungsabschnitt ein Durchgangsloch (S1; S2) ist.

3. Verfahren nach Anspruch 1, wobei der Spannungsentlastungsabschnitt eine Aussparung (Re) ist.

4. Verfahren nach Anspruch 1, ferner umfassend ein Bereitstellen mindestens einer Verdrahtungsschicht (M1; M2; M3; M4), die aus Metall innerhalb der Leiterplatte (40; 140; 240; 340; 440; 540) gefertigt ist, wobei der Spannungsentlastungsabschnitt durch einen Bereich (Rnm) um das Befestigungsloch (42a) gebildet ist, in dem die Verdrahtungsschicht (M1; M2; M3; M4) nicht bereitgestellt ist.

## Revendications

1. Procédé de formation d'une partie de soulagement des contraintes (S ; S1 ; S2) pour soulager les contraintes sur une carte de circuit imprimé (40 ; 140 ; 240 ; 340 ; 440 ; 540) fixée à une partie prédéterminée (51) par une attache (44a ; 44b ; 44c ; 44d ; 44e ; 44f ; 44g), la carte de circuit imprimé (40 ; 140 ; 240 ; 340 ; 440 ; 540) ayant une pluralité de trous de fixation (42a ; 42b ; 42c ; 42d ; 42e ; 42f ; 42g) utilisés pour fixer la carte de circuit imprimé (40 ; 140 ; 240 ; 340 ; 440 ; 540) à la partie prédéterminée (51), les trous de fixation (42a ; 42b ; 42c ; 42d ; 42e ; 42f ; 42g) comprenant un premier trou de fixation (42a) et un deuxième trou de fixation (42c), la carte de circuit imprimé (40 ; 140 ; 240 ; 340 ; 440 ; 540) comprenant une pluralité de composants électroniques (Cap ; Coil ; Cn ; IC ; M ; R) montés sur une surface de la carte de circuit imprimé (40 ; 140 ; 240 ; 340 ; 440 ; 540), le procédé comprenant :
la détermination d'une distance prédéterminée qui est une valeur seuil d'une distance entre deux trous de fixation à laquelle la rigidité de la carte de circuit imprimé contre la vibration qui est introduite dans la carte de circuit imprimé après avoir été fixée à la partie prédéterminée par les attaches, commence à diminuer en raison de la formation de la partie de soulagement des contraintes,
la mesure d'une distance entre le premier trou de fixation (42a) et le deuxième trou de fixation adjacent (42c), et
la formation de la partie de soulagement des contraintes autour du premier trou de fixation (42a) dans une région qui ne coupe pas une ligne droite (Lref) reliant le premier trou de fixation (42a) et le deuxième trou de fixation (42c) situé à côté du premier trou de fixation (42a) lorsque la distance entre le premier trou de fixation et le deuxième trou de fixation est égale ou supérieure à la distance prédéterminée et un condensateur électrolytique (Cap) ou une bobine (Coil) ou un transistor (M) ou aucun composant électronique n'est disposé sur la ligne droite, formant la partie de soulagement des contraintes autour du premier trou de fixation (42a) dans une région qui coupe une ligne droite (Lref) reliant le premier trou de fixation (42a) et le deuxième trou de fixation (42c) situé à côté du premier trou de fixation (42a) lorsque la distance entre le premier trou de fixation et le deuxième trou de fixation est supérieure ou égale à la distance prédéterminée (Dref) et qu'un élément de résistance (R) ou un circuit intégré (IC) est disposée sur la ligne droite (Lref), et formant la partie de soulagement des contraintes dans une région coupant la ligne droite (Lref) reliant le premier trou de fixation (42a) et le deuxième trou de fixation adjacent (42c) lorsque la distance (Dh) est inférieure à la distance prédéterminée (Dref).

2. Procédé selon la revendication 1, dans lequel la partie de soulagement des contraintes est un trou traversant (S1 ; S2).

3. Procédé selon la revendication 1, dans lequel la partie de soulagement des contraintes est un évidement (Re).

4. Procédé selon la revendication 1, comprenant en outre la fourniture d'au moins une couche de câblage (M1 ; M2 ; M3 ; M4) qui est réalisée en métal à l'intérieur de la carte de circuit imprimé (40 ; 140 ; 240 ; 340 ; 440 ; 540), dans lequel la partie de soulagement des contraintes est formée par une région (Rnm) autour du trou de fixation (42a) dans laquelle la couche de câblage (M1 ; M2 ; M3 ; M4) n'est pas prévue.
